# EUROPEAN PATENT SPECIFICATION

(11) **EP 4 264 157 B1**
(45) Date of publication and mention of the grant of the patent: **07.08.2024**
(21) Application number: 21844054.3
(22) Date of filing: 20.12.2021
(51) Int. Cl.: F28D 20/00

(54) **ENERGY STORAGE APPARATUS**
ENERGIESPEICHERVORRICHTUNG
APPAREIL DE STOCKAGE D'ÉNERGIE

(30) Priority: 21.12.2020 IT 202000031715
(43) Date of publication of application: 25.10.2023
(73) Proprietor: Marchetti Pro Srl, 53043 Chiusi (SI) (IT)
(72) Inventor: PASSERINI, Filippo, 06062 Citta' Della Pieve (PG) (IT); MARCHETTI, Nicola, 53047 Sarteano (SI) (IT); BIAGINI, Stefano, 53043 Chiusi (SI) (IT); GIULIETTI, Nicola, 53043 Chiusi (SI) (IT)
(74) Representative: Fabbriciani, Simone
(86) International application number: PCT/IB2021/062023
(87) International publication number: WO 2022/137079

(56) References cited:
- WO-A1-00/19154
- DE-A1- 102014 002 761
- DE-A1- 2 238 612
- US-A- 3 864 658

## Description

### Technical field

This invention relates to an apparatus for storing electricity in a thermal form.

This invention can be widely used in the field of renewable energy, and thus in the non-programmable energy sector, in which it is essential to store the energy produced in order to deal with daily, weekly and annual variations in energy supply and demand requirements.

### State of the art

As is known, renewable technologies are becoming very widespread and are becoming increasingly economical for energy production. In particular, in some cases, the energy production is much higher than the demand and it is therefore necessary to dissipate the part of the energy introduced into the grid which is in excess.

In order to increase the energy storage power at a low cost, the use of thermal energy storage systems has been experimented. The accumulated thermal energy may be used, for example, to operate thermal machines or to power industrial processes which require heat or for cogeneration.

As is known, the transformation of electricity into a thermal form occurs thanks to electrical resistors which, since they are extremely simple devices, have a cost per unit of power which is generally very low. Normally, the resistors are made in the form of metal alloy cables.

In order to store thermal energy, the electric current in excess with respect to the demand of the grid is passed through these resistors which, when heating, transmit heat to a storage material, that is to say, to a material which is able to receive and retain the heat until the time the use of the heat is required.

There are prior art granular storage materials which generally have a low thermal diffusion, a feature which makes it possible to reduce the dispersion of the accumulated thermal energy. In that way, the electricity is accumulated and stored in the form of heat.

As is known, in order to limit the dispersion of heat during the energy storage step, insulating materials located outside the storage system are used, the thickness and cost of which increases as a function of the temperature of the storage material.

Disadvantageously, the prior art energy storage systems have a low efficiency and various problems in their operation.

In particular, the storage material has a low thermal diffusion which, whilst on the one hand it allows the dispersion of the accumulated thermal energy to be reduced, on the other hand it considerably slows down the transmission of the heat between the electrical resistor and the storage material, thus making the storage operations lengthy and expensive.

A further drawback derives also from the resistors made in the form of metal cables which, in order to satisfy the thermal demand of some industrial processes or thermoelectric plants, must be able to withstand a temperature of approximately 1100°C. However, at this temperature all the metal alloys which are widely used deteriorate in the presence of air. There are prior art resistors made of materials which are able to withstand 1500°C in the presence of air, such as silicon carbide or molybdenum disilicate. However, these resistors are not suitable for a use in this type of storage system, since they have problems of fragility especially after a prolonged use and are therefore subject to faults and breakages.

There are also prior art resistors made of granular material, such as, for example, silicon carbide, which are able to withstand high temperatures. However, this type of resistor has extremely variable electrical properties, especially depending on the size of the granules and their chemical composition, making the connection of the storage system to the electricity grid difficult.

The resistors made of granular material have characteristics and applications which are different from those of a traditional resistor, and they therefore require substantial modifications in the composition of the specific granular resistor depending on the relative use.

Moreover, a granular resistor, taken just as it is, for example without suitable containment means or other systems which allow it to operate, is unusable.

An exemple of the state of art is given in the following documents: DE 102014002761 (A1), disclosing an energy storage apparatus according to the preamble of claim 1, WO 00/19154 (A1), DE 2238612 (A1), and US 3864658 (A).

### Summary of the invention

An aim of the invention is to provide an apparatus for storing electricity in a thermal form which is able to overcome the drawbacks of the prior art.

An aim of the invention is to provide an energy storage apparatus which is durable and reliable even at high temperatures.

Another aim of the apparatus according to the invention is to provide a low-cost energy storage apparatus.

Another aim of this invention is to provide an energy storage apparatus which comprises an electrical resistor with features suitable for a connection to the electricity grid.

A further aim of the invention is to provide an energy storage apparatus which has reduced thermal insulation requirements.

The technical purpose indicated and the aims specified are substantially achieved by an energy storage apparatus comprising the technical features described in one or more of the appended claims.

The dependent claims correspond to possible embodiments of the invention.

In particular, the technical purpose and aims specified are achieved by an energy storage apparatus configured to store electricity in a thermal form.

The apparatus according to the invention, comprises a containment body which defines a storage space and which has at least one inlet for a heat carrier fluid, at least one outlet for the fluid and at least one electrical resistor positioned in the storage space.

The apparatus also comprises at least one pair of electrodes positioned at the ends of the electrical resistor and designed to be connected to an electricity supply network.

The apparatus, according to the invention, also comprises a plurality of storage granules positioned to at least partly fill the storage space and which define a thermal storage mass configured to receive thermal energy from the electrical resistor and to release the thermal energy to a heat carrier fluid flowing from the inlet towards the outlet.

This electrical resistor is at least partly made in a substantially granular form. Moreover, at least some granules of the electrical resistor are made with a doped semiconductor and/or with an intermetallic compound.

Advantageously, the fact of making the electrical resistor from granular material does not create, in the case of breakage of some of them, any fault to the entire resistor.

Advantageously, the fact of making the electrical resistor from granular material favours and facilitates the transfer of heat from the electrical resistor to the heat carrier fluid.

Advantageously, the fact of having put a granular resistor, with features and applications different from those of a traditional resistor, inside a storage system allows the replacement of a traditional resistor, with - precisely - the granular resistor. In order to do this, as will be described in more detail below, a series of innovations will also be required in the composition of the granular resistor itself.

Advantageously, the electrical resistor is easy to produce, inexpensive and reliable.

Advantageously, the use of an intermetallic material or a doped semiconductor makes it possible to raise the operating temperature of the system and to create large electrical resistors, compatible with those imposed by the need to store large quantities of energy limiting the heat losses, which can be powered in medium or high voltage, thus avoiding or limiting the use of electrical transformation systems and the energy transformation losses.

### Description of the drawings

Further features and advantages of the invention are more apparent in the non-limiting description which follows of a non-exclusive embodiment of an energy storage apparatus.

The description is set out below with reference to the accompanying drawings which are provided solely for purposes of illustration without restricting the scope of the invention and in which:
Figure 1 is a cross section of a first embodiment of an energy storage apparatus according to the invention;
Figure 2 is a cross section of a second embodiment of an energy storage apparatus according to the invention.

### Detailed description of the invention

With reference to the accompanying drawings, the numeral 100 denotes an energy storage apparatus configured for storing electricity in a thermal form. The apparatus 100 comprises a containment body 101 which defines a storage space "V".

The containment body 101 is designed to hold inside it the components of the apparatus 100 separating them from the outside environment in such a way as to protect them from the weather conditions. In that way, the containment body 101 guarantees the safety of the apparatus 100 and its suitable thermal and electrical insulation with respect to the outside.

The containment body 101 is also designed to prevent, or in any case considerably limit, the passage of gas between the inside and the outside of the storage space "V".

According to the preferred embodiment, the walls of the containment body 101 are made from refractory materials, for example refractory bricks and cements, which rest, also through the interposing of thermal insulating materials, on a load-bearing structure made of steel, masonry or reinforced concrete to which further outer layers of insulating material may be connected.

The containment body 101 comprises at least one inlet 102a for a heat carrier fluid and at least one outlet 102b for the fluid.

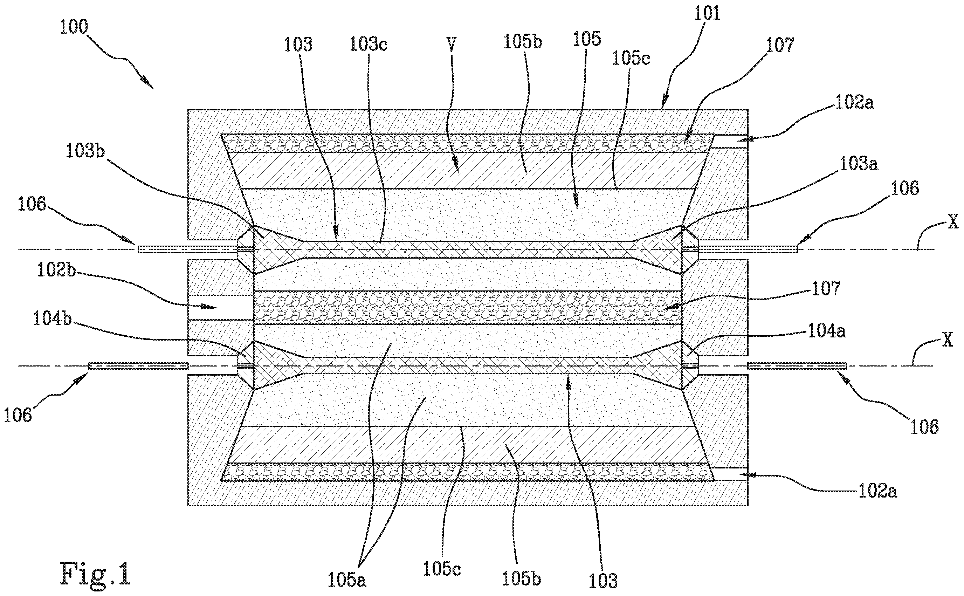

According to the embodiment of Figure 1, the containment body 101 comprises two inlets 102a, made on the same side wall of the containment body 101, and an outlet 102b made on a side wall of the containment body 101 opposite to that of the inlets 102a.

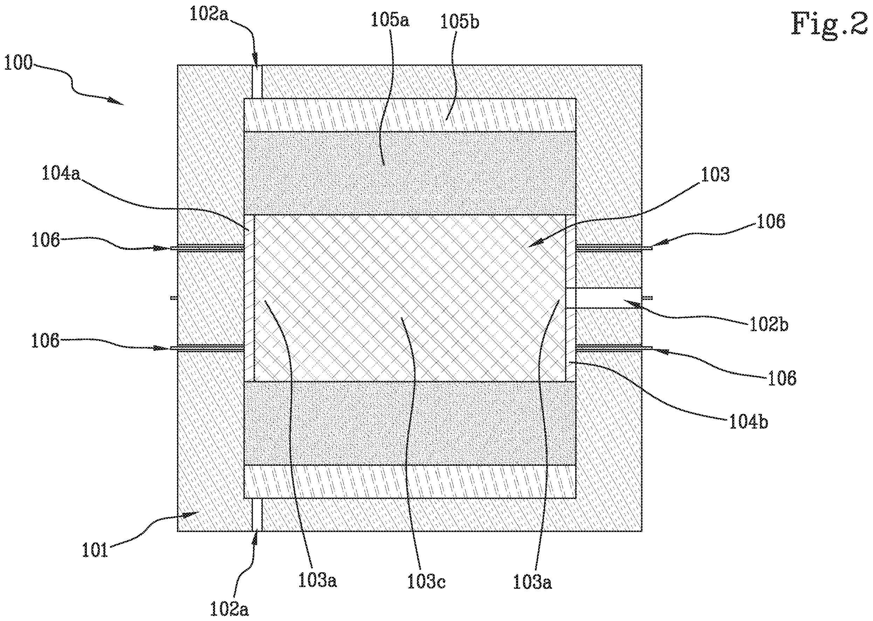

According to the embodiment of Figure 2, on the other hand, the containment body 101 comprises two inlets 102a made, respectively, on an upper wall and on a lower wall of the containment body 1 and an outlet 102b made on a side wall.

As shown in the accompanying drawings, the apparatus 100 also comprises at least one electrical resistor 103 positioned in the storage space "V".

Preferably, the electrical resistor 103 extends along a respective direction of extension "X" and has a substantially elongate shape.

Even more preferably, the electrical resistor 103 is positioned inside the storage space "V" in a position interposed between the inlet 102a and the outlet 102b of the heat carrier fluid.

According to the embodiment shown in Figure 1, the apparatus 100 comprises two electrical resistors 103 spaced from each other and positioned parallel to each other.

According to the embodiment of Figure 2, on the other hand, the apparatus 100 has a single electrical resistor 103 with dimensions greater than those of the electrical resistors 103 of Figure 1 and positioned in a central portion of the storage space "V".

The electrical resistor 103 is at least partly made in a substantially granular form and at least some granules of the electrical resistor 103 are made with a doped semiconductor, such as, for example, silicon carbide, and/or with an intermetallic compound, such as, for example, molybdenum disilicate.

The term "granular" means a discontinuous material consisting of granules, that is fragments, of any shape and size and separated from each other by contiguous cavities filled with gas. According to the invention, a granular material is also considered to be a granular material which, due to temperature, pressure and/or electrical phenomena, partly melts the contact points between one granule and another.

The term "doped" means a semiconductor in which there are impurities which increase the electrical conductivity. These impurities may be inserted voluntarily or accidentally during the production process of the semiconductor or may already be present in the raw material of the semiconductor.

The fact of making the electrical resistor 103 of granular material results in several advantages in terms of time and costs of making the electrical resistor 103. In particular, the granules generally represent the shape in which the materials are available on the market as a raw material for the production of products. Consequently, their production is simpler and faster than that of a resistor made from coherent (non-granular) material. Moreover, the granules can be obtained from the crushing of products and resistors intended for disposal, thereby reducing the final cost of the electrical resistor 103.

Since the material consists of granules which are not coherent, any breakage of the granules does not create problems with the operation of the electrical resistor 103. Moreover, the high ratio between surface area and volume of the granules facilitates the transfer of the heat from the electrical resistor 103 to the heat carrier fluid used for thermal recovery, as described in detail below. Thanks to the features listed, the resistor made of granular material can simultaneously perform the function of generating heat, the heat storage function and the heat exchange with the heat carrier fluid, simplifying the apparatus 100 and making it possible to heat the heat carrier fluid to ultra high temperatures, close to those for generating heat, that is to say, to those which can be supported by the heat resistant material of the resistor; in this way, the possible industrial uses of the heat recovered are multiplied.

Preferably, the porosity of the granular material, that is, the inter-granular space in which a fluid can circulate, is greater than 5%, more preferably greater than 10%, even more preferably greater than 20% of the total volume of the granular resistor 103; a porosity of less than these values, as well as compromising the continuity of the porosity and therefore a homogeneous thermal recovery by the heat carrier fluid, produces high head losses when passing through the porosities and high energy consumption of fans, compressors or other apparatuses used for moving the heat carrier fluid.

The material of the resistors 103 must be provided with particular characteristics, which distinguish them from those of the existing granular resistors.

In effect, the storage system 100 must have large dimensions, greater than 1.5 m along each axis, more preferably greater than 3 m, since the fraction of energy lost by the thermal accumulation is correlated with the volume/external surface ratio; consequently, the increase in size reduces the fraction of energy lost. The resistors 103, as illustrated below, must pass through the thermal storage zone 105 from side to side, in such a way as to uniformly heat the internal material and in such a way that the supply voltage can be applied to the resistors at less hot outside areas. It follows that the resistors 103 have a length greater than 1 m. Moreover, the conductive features of the granular material depend on the nature of the inter-granular contacts and on the pressure exerted by a granule on the adjacent ones; unlike existing granular resistors, it is not possible to apply high and controlled forces to the granular material inside the storage constituting the resistors 103 and any inter-granular partial melting links are subject to continuous breakage due to the thermal expansion linked to the temperature variations during refilling and discharging of the apparatus 100.

At least 50% by weight of the granular material of the electrical resistor 103 consists of silicon carbide granules having a doping greater than 0.5% and a diameter of between 0.5 mm and 50 mm.

Still more preferably, the silicon carbide granules are black silicon carbide granules or green silicon carbide granules.

Advantageously, the range of values of the above-mentioned diameter makes it possible to reduce the capacitive reactance of the electrical resistor 103 since it depends on the number of intra-granular contacts present and thus reduces with the increase in size of the granules. An excessive capacitive reaction would, in fact, interfere with the correct management of the electricity network. The doping of the silicon carbide granules is preferably less than 5%, more preferably less than 3% since greater values of impurities worsen the electrical performance and adversely affect the resistance at high temperatures of the material and its durability; values of less than 0.5% and/or diameters of the granules of less than 0.5 mm, on the other hand, produce a sudden reduction in electrical conductivity, requiring very high electrical voltages in order to operate the system, with consequent safety risks. Lastly, granules with dimensions greater than 50 mm are difficult to produce, except in the form of aggregates of crystals or smaller granules and tend to degrade under the conditions present inside the apparatus 100.

Advantageously, both the black silicon carbide and green silicon carbide are easily available on the market at a low cost and have excellent thermal and mechanical properties. These materials can be produced starting from abundant raw materials, that is to say, carbon and silicon and can operate up to 1400-1600°C.

It has been demonstrated that the features indicated make it possible to power resistors with a length greater than 1 m in medium voltage and at a frequency of 50-60 Hz, that is to say, in conditions compatible with the electricity network, without the need for electrical transformation systems and under safe conditions; on the other hand, different characteristics of the granules may make it impossible to maintain a flow of electric current which is constant and homogeneous in the resistor; for example, granules with dimensions of less than 0.5 mm and impurities greater than 5% produce sudden electric discharges which are unacceptable for the management of the electricity network.

As shown in Figure 1, the apparatus 100 also comprises at least one pair of electrodes 104a, 104b positioned at the ends of each electrical resistor 103 present in the apparatus 100 and facing the outside of the containment body 101 for being connected to an electricity supply network.

Preferably, the electrodes 104a, 104 are fixed in the structure of the containment body 101 and each have a small opening designed to allow air cooling of the electrodes 104a, 104b.

The function of the electrodes 104a, 104b is to apply a potential difference at the ends of the electrical resistor 103 in such a way that an electric current is generated in the resistor 103.

According to a possible embodiment, the electrodes 104a, 104b can be made with the same materials used for the production of the traditional resistors.

Alternatively, the electrodes 104a, 104b may also be made partly with, or consist of, a material selected from: alloys reinforced with dispersions of oxides; nickel-based alloys, cobalt-based alloys, ferric stainless steels; refractory materials made of silicon carbide; refractory materials made of molybdenum disilicate; refractory materials made of chromite.

Preferably, the electricity is conveyed to the electrodes 104a, 104b through at least two contact elements 106 movable between an operating position, wherein they are connected to the electrodes 104a, 104b for applying a potential difference to the electrical resistor 103, and a rest position, wherein they are moved away from the electrodes 104a, 104b to inhibit the passage of electric current.

In more detail, the contact elements 106 are located in the operating position when there is an electricity production which the network is unable to absorb. In this situation, the contact elements 106 connect the resistor 103 to the electricity network to allow the passage of the electricity in excess in such a way that it is accumulated inside the apparatus 100 in the form of thermal energy, as described in detail below.

Advantageously, the mobility of the contact elements 106 allows, during the energy storage step, a difference in potential to be applied to the electrical resistor 103 generating a current in it whilst, when there is no need to recharge the apparatus 100, it allows the dispersion of heat by conduction as well as the excessive heating of the contact elements 106 to be limited.

In order to increase the working life of the electrodes 104a, 104b it is worth avoiding excessive and rapid heating.

In this regard, the electrical resistor 103 has end portions 103a, 103b, close to the electrodes 104a, 104b, having an electrical resistivity less than a central portion 103c between the end portions 103a, 103b.

Preferably, the lower resistivity is achieved by at least one of the following measures: the end portions 103a, 103b have a transversal cross-section greater than the central portion 103c (Figure 1) and/or the end portions 103a, 103b comprise a percentage by weight of granules of doped or intermetallic material which is greater than the central portion 103c of the electrical resistor 103 and/or the end portions 103a, 103B comprise granules of doped or intermetallic material having a dimension greater than that of the granules of doped or intermetallic material located in the central portion 103c.

In that way, during the passage of current in the electrical resistor 103, the effect of concentrating the thermal generation in the central portion 103c is reached, reducing the thermal stresses of the electrodes 104a, 104b.

As shown in the accompanying drawings, the apparatus 100 also comprises a plurality of storage granules 105 positioned for at least partly filling the storage space "V".

The storage granules 105 define a thermal storage mass configured to receive thermal energy from the electrical resistor 103, when the latter is passed through by current, and to release the thermal energy to the heat carrier fluid flowing from the inlet 102a to the outlet 102b when there is the need to use the thermal energy stored in the apparatus 100.

In particular, as shown in Figure 1, so that the heat carrier fluid flows uniformly in the storage granules 105 in order to absorb the thermal energy accumulated therein, the apparatus 100 comprises at least one zone 107 for distributing the fluid. The distribution zone 107 is interposed between the inlet 102a and the storage granules 105 and/or between the storage granules 105 and the outlet 102b in such a way as to promote a homogeneous distribution of the fluid through the mass of storage granules 105.

According to the preferred embodiment shown in Figure 1, the apparatus comprises two distribution zones 107 interposed between a respective inlet 102a and the storage granules 105 and a distribution zone 107 interposed between the outlet 102b and the storage granules 105. Preferably, the storage zones 107 have an elongate shape extending parallel to the direction of extension "X".

Even more preferably, the distribution zone 107 is made of a porous material having a porosity which is at least twice the plurality of storage granules 105 and/or distribution granules wherein at least 90% by weight of the distribution granules has a size which is twice the average dimension of the storage granules 105.

Advantageously, the above-mentioned aspect makes it possible to increase the permeability of the distribution zone 107 to the passage of the heat carrier fluid and to orient a pressure gradient in the outside-inside direction relative to the geometry of the apparatus 100.

In use, therefore, when the electricity network has an excess of electricity, the contact elements 106 pass from the rest position to the operating position. In this situation, the electrical resistor 103 is powered by the pair of electrodes 104a, 104b in such a way that the electric current flows in the electrical resistor 103 generating heat and, therefore, thermal power. In this situation, the electrical resistor 103 transfers heat to the plurality of storage granules 105. More in detail, the heat exchange is concentrated in the central portion 103c of the electrical resistor 103.

Preferably, the transfer of heat from the electrical resistor 103 to the plurality of storage granules 105 is facilitated by phenomena of natural or forced convection of intra-granular gas.

Following an increase in the temperature of the storage granules 105, the thermal power is accumulated in the apparatus 100. In this situation, the contact elements 106 return to the rest position.

When the use of the thermal energy accumulated in the apparatus 100 is requested, part of the thermal energy stored in the storage granules 105 is transferred to the heat carrier fluid by the passage of the heat carrier fluid from the inlet 102a to the outlet 102b of the containment body 100. Preferably, between the step of electrically powering the electrical resistor 103 and that of transferring thermal energy to the heat carrier fluid by the sliding of the latter inside the containment body 101, a step is performed of physically disconnecting the electrodes 104, 104b from the electrical resistor 103 and/or from an external power supply in such a way as to interrupt physical bridges of thermal dispersion between the apparatus 100 and the outside environment.

In order to guarantee a recharging of the apparatus 100 in a time interval having an average duration equal to that of the excess electrical production, the electrical resistance of the granular electrical resistor 103 must be suitably calibrated. In particular, an electrical resistance which is too low would produce the rapid generation of thermal energy but, at the same time, an excessive current intensity for the electricity network. On the other hand, an excessively high electrical conductivity would make the recharging times too long unless high electrical voltages are applied at the terminals of the electrical resistor 103, with electrical safety problems.

In this regard, at least 50% by weight of the granular material of the electrical resistor 103 consists of silicon carbide granules having a doping greater than 0.5% and a diameter of between 0.5 mm and 50 mm.

Still more preferably, the silicon carbide granules are black silicon carbide granules or green silicon carbide granules.

Advantageously, the range of values of the above-mentioned diameter also makes it possible to reduce the capacitive reactance of the electrical resistor 103 since it depends on the number of intra-granular contacts present and thus reduces with the increase in size of the granules.

Advantageously, both the black silicon carbide and green silicon carbide are easily available on the market at a low cost and have excellent thermal and mechanical properties.

Preferably, the electrical resistor 103 of the apparatus 100, according to the invention, comprises additive granules consisting for at least 80% by weight of alumina, magnesite and silica.

Advantageously, the additive granules allow the electrical properties of the electrical resistor 103 to be modulated.

Advantageously, the additive granules can work at high temperatures without problems of breakage or fragility.

Advantageously, the additive granules also allow the outer surface of the electrical resistor 103 to be increased and, consequently, its capacity to exchange heat with the surrounding storage granules 105.

Advantageously, the additive granules also allow an increase in the quantity of thermal energy which can be accumulated in the electrical resistor 103 without the need for a greater quantity of doped semiconductor material or of the intermetallic compound which can be more costly than the additive granules.

Moreover, according to the preferred embodiment, in order to maintain a substantially homogeneous electrical conductivity along the electrical resistor 103, the electrical resistor 103 has, along the relative direction of extension "X", a grain size and/or a variable composition as a function of the weight of the mass of granules above the electrical resistor 103.

Since, in order to store thermal energy in the apparatus 100, it is necessary for the electrical resistor 103 and the storage granules 105 to exchange heat, it is necessary that the storage granules 105 are able to withstand the high working temperatures of the electrical resistor 103. In particular, the storage granules 105 must be able to withstand in particular the temperatures which are recorded in the central portion 103c of the electrical resistor 103. It is also desirable that, during the step of recharging the apparatus 100 (that is to say, during the step in which a difference in potential is applied to the electrical resistor 103 by the electrodes 104a, 104b), the storage granules 105 in contact with the electrical resistor 103 facilitate the transfer of the heat towards other zones of the storage space "V" distal from the electrical resistor 103 whilst the storage granules 105 located close to the walls of the containment body 101 slow down, in the thermal transients, the transmission, and therefore the dispersion, of the thermal energy towards the outside.

In this regard, according to the preferred embodiment, the plurality of storage granules 105 is configured in such a way as to define a primary storage zone 105a, extending around each electrical resistor 103 and adjacent to it, and a secondary storage zone 105b, positioned around the primary storage zone 105a and having a different composition and thermal diffusion less than the primary storage zone 105a.

Since the primary storage zone 105a is in contact with the electrical resistor 103, the material from which it is made must withstand the same temperatures reached by the latter during the recharging step. In this situation, therefore, the use of refractory material resistant to high temperatures, is convenient, in particular it is convenient for the granules located in the primary storage area 105a to be made up for at least 80% by weight of alumina, magnesite and silica.

Alternatively, the use of materials which are available in nature or semifinished items which require lower energy production and economic costs are advantageous. In particular, it is preferable that at least a part of the storage granules 105 consist of natural sands (for example olvinic or quartzose), fragments or granules of rocks or calcinated bauxite.

According to a further embodiment, at least a fraction of the primary storage zone consists of shells made of heat-resistant material (for example silicon carbide), having a filling in a material subject to liquefaction/solidification in the range of storage temperatures. Preferably, the material inside the shells consists of a silicon and/or boron-based eutectic, with a phase change temperature of between 1200°C and 1600°C. In this way it is possible to increase the density of energy and the average temperature of the apparatus 100, which both make the technology more attractive for some industrial applications.

With regard to the secondary storage zone 105b, on the other hand, it preferably has a thermal diffusion of less than 1 mm2/s, more preferably less than 0.6 mm2/s and still more preferably less than 0.4 mm2/s.

The thermal diffusion may be determined by the method indicated in ASTM D4612 which provides a standard test method for calculating the thermal diffusion of rock and soil, if a technical standard relating to the specific storage material is not available.

Still more preferably, the secondary storage zone 105b consists of at least 90% by weight of granules having a grain size of between 0.2 mm and 0.4 mm.

Advantageously, this dimensional range prevents the storage granules 105 from being excessively small in size, thus reducing the permeability of the plurality of storage granules 105 to the heat carrier fluid and making a homogeneous heat recovery more difficult.

Advantageously, this dimensional range prevents the storage granules 105 from having excessive dimensions, thus reducing the heat exchange with the heat carrier fluid.

Advantageously, the thermal diffusion increases with the temperature of the plurality of storage granules 105, so the temperature can be kept higher in the primary storage zone 105a, so as to increase the thermal diffusion, and lower in the secondary storage zone 105b so as to reduce the thermal diffusion.

In order to create a temperature distribution in which it is higher in the primary storage zone 105a and lower in the secondary storage zone 105b, it is preferable that the heat carrier fluid, during the step of recovering the thermal energy accumulated in the storage granules 105, is introduced laterally.

As shown in Figure 1, the inlets 102a occupy a side wall of the main body 101 in such a way that the heat carrier fluid will firstly pass through the secondary storage zone 105b contributing to keeping the temperature low. The heat carrier fluid introduced laterally therefore undergoes a preheating at the expense of the heat accumulated in the outermost layers of the apparatus 100 consisting in general of granular materials and/or thermal insulating materials.

After passing through the material contained in the secondary storage zone 105b, if present, the heat carrier fluid passes through at least a portion of the primary storage zone 105a. The path followed by the heat carrier fluid between the intermediate zone and the primary storage zone 105a varies according to the temperature to be reached by the heat carrier fluid and the state of charge of the apparatus 100.

According to the embodiment of Figure 2, the zone 107 for distributing the heat carrier fluid adjacent to the outlet 102b is not present. In effect, according to this embodiment, the electrical resistor 103 occupies a larger portion of the storage space "V" and the granular material from which it is formed has granules of sufficiently large dimensions to prevent the presence of the distribution zone 107. The distribution zone 107 adjacent to the inlet conduits of the heat carrier fluid is, on the other hand, present and consists of an insulating material with a high porosity. Examples of materials suitable for this use are expanded perlite and vermiculite, with a grain size greater than 3 mm.

There may also be a layer of insulating material 105c at the interface between the primary storage zone 105a and the secondary storage zone 105b, and/or between the resistor 103 and the storage zone 105 immediately next to the resistor, which contributes to a further slowing down of the thermal diffusion towards the outer layers. The interface layer 105c has a thickness of preferably between 2 and 40 cm and preferably consists of heat-resistant insulating bricks (for example, mullite-based) arranged in such a way as to create slots between one and another, so as to allow the passage of the heat carrier fluid for the thermal recovery. Alternatively, it is possible to use panels, blocks or mattresses based on fibrous ceramic materials, in which holes can be made to favour the passage of the heat carrier fluid.

The thermal conductivity of the interface layer 105c, measured at the working temperature, is less by at least 30%, more preferably 60% less, than that of the adjacent accumulation zones and of any adjacent resistor. In this way, it has been observed that it is possible to considerably increase the permanence of the thermal energy in the innermost area of the energy storage apparatus 100 (it should be considered that this tends to move towards the outer layers at a low temperature), increasing the energy extractable from the apparatus 100 and therefore its profitability; this is also due to the interaction with the storage zone 105 or 105b positioned outside the insulating layer 105c, which is provided with greater conductivity and therefore tends to distribute in its volume the heat transmitted, containing the temperature of the interface layer 105c during the post-recharging transient and thus acting as a "cold tank". This phenomenon allows a further reduction in the dispersion of heat from the innermost area of the apparatus 100; the thermal conductivity of the layer 105c tends to increase with the temperature, as in all the refractory insulating materials which are commonly used. The thermal conductivity, for the correct selection of the materials, can be determined, for example, using the method indicated by ASTM C201, C202, C182, C177 or C1113 / C1113M.

At the same time, the interface insulating layer 105c prevents the mixing of the granular materials contained in the zones between which the layer is interposed during production, operation, maintenance and disposal of the storage system 100.

According to another aspect of the invention, in order to make the structure of the apparatus 100 described above, that is to say, in order to create layers and zones of materials different to each other in terms of electrical properties, grain size and composition, a separating structure such as formwork, pipes or containers to be inserted as separating elements can be used between one type of material and another.

In a step of making the apparatus 100, the granular material is poured inside the main body 101 where at least one separating structure is located. The filling is performed starting from the lower levels of the main body 101 and gradually rising up.

Once a layer of the apparatus 100 has been made, the separating structure is extracted.

Alternatively, the separating structure may be made of organic material, for example wood or cardboard, and not removed during the construction step. In that case, the separating structure undergoes a combustion process when the apparatus 100 enters into operation, thereby removing it.

During the construction of the apparatus 100, where there is the passage between two zones with very different grain sizes, one or more intermediate zones of intermediate grain size can be provided to prevent the natural mixing phenomenon which would occur with the penetration of the finer material inside the gaps or those with the coarser grain size.

Advantageously, the apparatus 100 is easy to construct and inexpensive.

According to further aspect of the invention, the apparatus 100 may comprise an inductor connected or connectable in series with each of the electrical resistors 103 present in the apparatus 100. The inductor is configured to dampen sudden fluctuations of an electric current in the electrical resistor 103 and/or to at least partly compensate for the capacitive reactive power of the electrical resistor 103.

This aspect is particularly advantageous since the electrical resistors 103 may have a capacitive load and a fluctuating resistivity, especially at low temperatures, which produces an equally fluctuating trend of the electric current. Since these phenomena are undesirable for the correct operation of the electricity network to which the storage apparatus 100 is connected, it is convenient to provide the inductor connected in series to the electrical resistor 103.

According to another aspect of the invention, for starting the apparatus 100 from cold or for temporarily increasing the electrical conductivity of each electrical resistor 103 and/or the thermal power generated, each electrical resistor 103 is connected to a power supply unit supplying a voltage of at least one order of magnitude greater than a power supply voltage used in a normal operation of the apparatus 100.

Preferably, the power supply unit may be made in the form of a direct connection to the high voltage network or in the form of a high voltage electrical pulse generator.

During use, therefore, the high voltage power supply unit is applied by means of electrical cables to the contact elements 106 which convey the electrical current to the electrodes 104a, 104b. Subsequently, the contact elements 106 are disconnected from the power supply unit and, if necessary, connected to the electricity network in such a way as to apply to the electrical resistor 103 a supply voltage used in normal operation of the apparatus 100.

In other words, since the electrical resistor 103 is subject to a reduction in the electrical conductivity with the lowering of the temperature and since the electrical conductivity of the resistor 103 is designed for the high temperature operating conditions, the power supply unit is connected to the apparatus 100 in such a way as to induce an electrical discharge between the granules of the electrical resistor 103.

Following this electrical discharge, the electrical conductivity of the granular material of the electrical resistor 103 undergoes, for a certain length of time, a reduction due to chemical or partial fusions in the intra-granular contacts and the raising of the temperature produced by the discharge. Subsequently, a supply voltage used in a normal operation of the apparatus 100 is applied to the apparatus 100, and more specifically to each electrical resistor 103.

The invention achieves the preset aims eliminating the drawbacks of the prior art.

The apparatus 100 is efficient and economical and is able to avoid excessive thermal dispersion to the outside environment.

The electrical resistor 103 is able to withstand high temperatures without having phenomena of fragility and breakage.

The electrical resistor 103 has long-lasting characteristics.

## Claims

1. An energy storage apparatus (100) configured to store electricity in a thermal form comprising:
- a containment body (101) defining a storage space (V) and having at least one inlet (102a) for a heat carrier fluid and at least one outlet (102b) for said fluid;
- at least one electrical resistor (103) positioned in the storage space (V);
- at least one pair of electrodes (104a, 104b) positioned at the ends of said at least one electrical resistor (103) and designed to be connected to an electricity supply network;
- a plurality of storage granules (105) positioned for at least partly filling the storage space (V) and defining a thermal storage mass configured to receive thermal energy from said at least one electrical resistor (103) and to release said thermal energy to a heat carrier fluid flowing from said inlet (102a) to said outlet (102b);
**characterised in that**
said at least one electrical resistor (103) is at least partly made in a substantially granular form and wherein at least some granules of the electrical resistor (103) are made with a doped semiconductor and/or with an intermetallic compound;
wherein at least 50% by weight of the granular material of the electrical resistor (103) consists of silicon carbide granules having a doping greater than 0.5% and a diameter of between 0.5 mm and 50 mm.

2. The apparatus (100) according to the preceding claim, wherein said silicon carbide granules is black silicon carbide granules or green silicon carbide granules.

3. The apparatus (100) according to claim 1 or 2, wherein said at least one electrical resistor (103) comprises end portions (103a, 103b), close to said electrodes (104a, 104b), having an electrical resistivity less than a central portion (103c) between said end portions (103a, 103b); preferably said lower resistivity being achieved by at least one of the following measures: said end portions (103a, 103B) having a transversal cross-section which is greater than said central portion (103c) and/or said end portions (103a, 103b) comprising a percentage by weight of granules of doped or intermetallic material which is greater than that of the central portion (103c) of said electrical resistor (103) and/or comprising granules of doped or intermetallic material having a dimension greater than that of the granules of doped or intermetallic material located in said central portion (103c).

4. The apparatus (100) according to any one of the preceding claims, wherein said electrical resistor (103) also comprises additive granules consisting for at least 80% by weight of alumina, magnesite and silica.

5. The apparatus (100) according to any one of the preceding claims, wherein said electrodes (104a, 104b) are at least partly made of, or consist of, a material selected from: alloys reinforced with dispersion of oxides; nickel-based alloys, cobalt-based alloys, ferric stainless steels; refractory materials made of silicon carbide; refractory materials made of molybdenum disilicate; refractory materials made of chromite.

6. The apparatus (100) according to any one of the preceding claims, comprising at least two contact elements (106) movable between an operating position, wherein they are connected to said electrodes (104a, 104b) for applying a potential difference to said electrical resistor (103), and a rest position, wherein they are moved away from said electrodes (104a, 104b) for inhibiting said passage of electric current.

7. The apparatus (100) according to any one of the preceding claims, wherein said plurality of storage granules (105) is configured in such a way as to define a primary storage zone (105a) extending around said at least one electrical resistor (103) and adjacent to the electrical resistor (103) and a secondary storage zone (105b), positioned around said primary storage zone (105a) and having a different composition and thermal diffusion which is less than the primary storage zone (105a); preferably said secondary storage zone (105b) has a thermal diffusion of less than 1 mm2/s, more preferably less than 0.6 mm2/s and still more preferably less than 0.4 mm2/s.

8. The apparatus (100) according to the preceding claim, wherein one of said storage zones (105a, 105b), preferably said secondary storage zone (105b), consists of at least 90% by weight of granules having a grain size of between 0.2 mm and 0.4 mm.

9. The apparatus (100) according to claim 7 or 8, wherein the granules located said the primary storage zone (105a) consist of at least 80% by weight of alumina, magnesite and silica.

10. The apparatus (100) according to any one of the preceding claims, comprising an inductor connected or connectable in series to the electrical resistor (103) and configured to dampen sudden fluctuations of an electric current in said electrical resistor (103) and/or to at least partly compensate for the capacitive reactive power of said electrical resistor (103).

11. The apparatus (100) according to any one of the preceding claims, wherein said at least one electrical resistor (103) has, along a respective direction of extension (X), a grain size and/or a variable composition as a function of the weight of the mass of granules above the electrical resistor (103) in such a way as to maintain a substantially homogeneous electrical conductivity along the electrical resistor (103).

12. The apparatus (100) according to any one of the preceding claims, comprising at least one zone (107) for distributing the fluid interposed between the inlet (102a) and said storage granules (105) and/or between said storage granules (105) and the outlet (102b) and configured to promote a homogeneous distribution of the fluid through the mass of storage granules (105); and wherein said at least one distribution zone (107) being made of a porous material having a porosity at least twice that of said plurality of storage granules (105) and/or distribution granules wherein at least 90% by weight of said distribution granules has a dimension which is twice the average dimension of the storage granules (105).

13. A method for the temporary storage of thermal energy, performed using an apparatus (100) according to any one of the preceding claims and comprising the steps of:
- electrically powering said at least one electrical resistor (103) generating thermal power which is stored by the storage granules (105), increasing the temperature of the storage granules (105);
- transferring at least part of the thermal energy stored in the storage granules (105) by the flow of a heat carrier fluid from said inlet (102a) to said outlet (102b);
wherein between said steps of electrically powering the electrical resistor (103) and transferring thermal energy to the heat carrier fluid there is a step of physically disconnecting the electrodes (104, 104b) from the electrical resistor (103) and/or from an external power supply in such a way as to interrupt physical bridges of thermal dispersion between the apparatus and the outside environment.

14. The method according to the preceding claim, also comprising a step of connecting the at least one electrical resistor (103) to a power supply unit supplying a power supply voltage of at least one order of magnitude greater than a power supply voltage used in a normal operation of said apparatus (100), preferably said step of connecting to the power supply unit being performed during a start-up of the apparatus (100) from cold or for temporarily increasing the electrical conductivity of the electrical resistor (103) and/or the thermal power generated.

## Patentansprüche

1. Energiespeichervorrichtung (100), die ausgelegt ist, um Elektrizität in einer thermischen Form zu speichern, umfassend:
- einen Aufnahmekörper (101), der einen Speicherraum (V) definiert und mindestens einen Einlass (102a) für ein Wärmeträgerfluid und mindestens einen Auslass (102b) für das Fluid aufweist;
- mindestens einen elektrischen Widerstand (103), der in dem Speicherraum (V) positioniert ist;
- mindestens ein Paar Elektroden (104a, 104b), die an den Enden des mindestens einen elektrischen Widerstands (103) positioniert sind und dazu ausgelegt sind, mit einem Stromversorgungsnetz verbunden zu werden;
- eine Vielzahl von Speichergranulatformen (105), die zum mindestens teilweisen Füllen des Speicherraums (V) positioniert sind und eine Wärmespeichermasse definieren, die dazu ausgelegt ist, Wärmeenergie von dem mindestens einen elektrischen Widerstand (103) zu empfangen und die Wärmeenergie an ein Wärmeträgerfluid abzugeben, das von dem Einlass (102a) zu dem Auslass (102b) strömt;
**dadurch gekennzeichnet, dass** der mindestens eine elektrische Widerstand (103) mindestens teilweise im Wesentlichen granulatförmig gefertigt ist und wobei mindestens einige Granulatformen des elektrischen Widerstands (103) mit einem dotierten Halbleiter und/oder mit einer intermetallischen Verbindung gefertigt sind;
wobei mindestens 50 Gew.- % des körnigen Materials des elektrischen Widerstands (103) aus Siliziumkarbidgranulatformen mit einer Dotierung größer als 0,5 % und einem Durchmesser zwischen 0,5 mm und 50 mm besteht.

2. Vorrichtung (100) nach dem vorhergehenden Anspruch, wobei die Siliciumcarbidgranulatformen schwarze Siliciumcarbidgranulatformen oder grüne Siliciumcarbidgranulatformen sind.

3. Vorrichtung (100) nach Anspruch 1 oder 2, wobei der mindestens eine elektrische Widerstand (103) Endabschnitte (103a, 103b) in der Nähe der Elektroden (104a, 104b) umfasst, die einen spezifischen elektrischen Widerstand aufweisen, der geringer ist als ein zentraler Abschnitt (103c) zwischen den Endabschnitten (103a, 103b); wobei der niedrigere spezifische Widerstand vorzugsweise durch mindestens eine der folgenden Maßnahmen erreicht wird: wobei die Endabschnitte (103a, 103b) einen transversalen Querschnitt aufweisen, der größer ist als der zentrale Abschnitt (103c), und/oder wobei die Endabschnitte (103a, 103b) einen Gewichtsprozentsatz an Granulatformen aus dotiertem oder intermetallischem Material umfassen, der größer ist als der des zentralen Abschnitts (103c) des elektrischen Widerstands (103), und/oder Granulatformen aus dotiertem oder intermetallischem Material umfassen, die eine größere Abmessung als die der Granulatformen aus dotiertem oder intermetallischem Material, die sich in dem zentralen Abschnitt (103c) befinden, aufweisen.

4. Vorrichtung (100) nach einem der vorhergehenden Ansprüche, wobei der elektrische Widerstand (103) auch Additivgranulatformen umfasst, die zu mindestens 80 Gew.- % aus Aluminiumoxid, Magnesit und Siliciumdioxid bestehen.

5. Vorrichtung (100) nach einem der vorhergehenden Ansprüche, wobei die Elektroden (104a, 104b) zumindest teilweise aus einem Material gefertigt sind oder aus einem Material bestehen, das ausgewählt ist aus: Legierungen, die mit einer Dispersion von Oxiden verstärkt sind; Legierungen auf Nickelbasis, Legierungen auf Kobaltbasis, rostfreie Eisenstähle; feuerfeste Materialien, die aus Siliciumcarbid gefertigt sind; feuerfeste Materialien, die aus Molybdändisilicat gefertigt sind; feuerfeste Materialien, die aus Chromit gefertigt sind.

6. Vorrichtung (100) nach einem der vorhergehenden Ansprüche, umfassend mindestens zwei Kontaktelemente (106), die zwischen einer Betriebsposition, in der sie mit den Elektroden (104a, 104b) verbunden sind, um eine Potentialdifferenz an den elektrischen Widerstand (103) anzulegen, und einer Ruheposition, in der sie von den Elektroden (104a, 104b) wegführend bewegt werden, um den Durchgang von elektrischem Strom zu verhindern, bewegbar sind.

7. Vorrichtung (100) nach einem der vorhergehenden Ansprüche, wobei die Vielzahl von Speichergranulatformen (105) so ausgelegt ist, dass sie eine primäre Speicherzone (105a), die sich um den mindestens einen elektrischen Widerstand (103) erstreckt und an den elektrischen Widerstand (103) angrenzt, und eine sekundäre Speicherzone (105b) definiert, die um die primäre Speicherzone (105a) herum positioniert ist und eine andere Zusammensetzung und Wärmediffusion aufweist, die geringer als die primäre Speicherzone (105a) ist; bevorzugt weist die sekundäre Speicherzone (105b) eine Wärmediffusion von weniger als 1 mm2/s, bevorzugter weniger als 0,6 mm2/s und noch bevorzugter weniger als 0,4 mm2/s auf.

8. Vorrichtung (100) nach dem vorhergehenden Anspruch, wobei eine der Speicherzonen (105a, 105b), vorzugsweise die sekundäre Speicherzone (105b), aus mindestens 90 Gew.- % Granulatformen mit einer Korngröße zwischen 0,2 mm und 0,4 mm besteht.

9. Vorrichtung (100) nach Anspruch 7 oder 8, wobei die Granulatformen, die sich in der primären Speicherzone (105a) befinden, aus mindestens 80 Gew.- % Aluminiumoxid, Magnesit und Siliciumdioxid bestehen.

10. Vorrichtung (100) nach einem der vorhergehenden Ansprüche, umfassend einen Induktor, der mit dem elektrischen Widerstand (103) verbunden oder in Reihe schaltbar ist und dazu ausgelegt ist, plötzliche Schwankungen eines elektrischen Stroms in dem elektrischen Widerstand (103) zu dämpfen und/oder die kapazitive Blindleistung des elektrischen Widerstands (103) zumindest teilweise zu kompensieren.

11. Vorrichtung (100) nach einem der vorhergehenden Ansprüche, wobei der mindestens eine elektrische Widerstand (103) entlang einer jeweiligen Erstreckungsrichtung (X) eine Korngröße und/oder eine variable Zusammensetzung als Funktion des Gewichts der Masse der Granulatformen über dem elektrischen Widerstand (103) aufweist, um eine im Wesentlichen homogene elektrische Leitfähigkeit entlang des elektrischen Widerstands (103) aufrechtzuerhalten.

12. Vorrichtung (100) nach einem der vorhergehenden Ansprüche, umfassend mindestens eine Zone (107) zum Verteilen des Fluids, die zwischen dem Einlass (102a) und den Speichergranulatformen (105) und/oder zwischen den Speichergranulatformen (105) und dem Auslass (102b) angeordnet ist und ausgelegt ist, um eine homogene Verteilung des Fluids durch die Masse der Speichergranulatformen (105) zu fördern; und wobei die mindestens eine Verteilungszone (107) aus einem porösen Material gefertigt ist, das eine Porosität aufweist, die mindestens doppelt so groß ist wie die der Vielzahl von Speichergranulatformen (105) und/oder Verteilungsgranulatformen, wobei mindestens 90 Gew.- % der Verteilungsgranulatformen eine Abmessung aufweist, die doppelt so groß ist wie die durchschnittliche Abmessung der Speichergranulatformen (105).

13. Verfahren zum vorübergehenden Speichern von Wärmeenergie, das unter Verwendung einer Vorrichtung (100) nach einem der vorhergehenden Ansprüche durchgeführt wird und die folgenden Schritte umfasst:
- elektrisches Versorgen des mindestens einen elektrischen Widerstands (103), der Wärmeenergie erzeugt, die durch die Speichergranulatformen (105) gespeichert wird, Erhöhen der Temperatur der Speichergranulatformen (105);
- Übertragen mindestens eines Teils der in den Speichergranulatformen (105) gespeicherten Wärmeenergie durch die Strömung eines Wärmeträgerfluids von dem Einlass (102a) zu dem Auslass (102b);
wobei zwischen den Schritten zum elektrischen Versorgen des elektrischen Widerstands (103) und zum Übertragen von Wärmeenergie an das Wärmeträgerfluid ein Schritt zum physischen Trennen der Elektroden (104, 104b) von dem elektrischen Widerstand (103) und/oder von einer externen Stromversorgung vorhanden ist, sodass physische Brücken der Wärmedispersion zwischen der Vorrichtung und der Außenumgebung unterbrochen werden.

14. Verfahren nach dem vorhergehenden Anspruch, umfassend auch einen Schritt zum Verbinden des mindestens einen elektrischen Widerstands (103) mit einer Stromversorgungseinheit umfasst, die eine Stromversorgungsspannung von mindestens einer Größenordnung versorgt, die größer ist als eine Stromversorgungsspannung, die in einem normalen Betrieb der Vorrichtung (100) genutzt wird, wobei vorzugsweise der Schritt zum Verbinden mit der Stromversorgungseinheit während eines Hochfahrens der Vorrichtung (100) aus kaltem Zustand oder zum vorübergehenden Erhöhen der elektrischen Leitfähigkeit des elektrischen Widerstands (103) und/oder der erzeugten Wärmeleistung durchgeführt wird.

## Revendications

1. Appareil de stockage d'énergie (100) configuré pour stocker de l'électricité sous une forme thermique, comprenant :
- un corps de confinement (101) définissant un espace de stockage (V) et comportant au moins une entrée (102a) pour un fluide caloporteur et au moins une sortie (102b) pour ledit fluide ;
- au moins une résistance électrique (103) positionnée dans l'espace de stockage (V) ;
- au moins une paire d'électrodes (104a, 104b) positionnées aux extrémités de ladite au moins une résistance électrique (103) et conçues pour être branchées à un réseau d'alimentation électrique ;
- une pluralité de granulés de stockage (105) positionnés pour remplir au moins partiellement l'espace de stockage (V) et définissant une masse de stockage thermique configurée pour recevoir de l'énergie thermique de ladite au moins une résistance électrique (103) et pour restituer ladite énergie thermique à un fluide caloporteur circulant de ladite entrée (102a) vers ladite sortie (102b) ;
**caractérisé en ce que** ladite au moins une résistance électrique (103) est au moins partiellement fabriquée sous une forme essentiellement granulaire et dans lequel au moins certains granulés de la résistance électrique (103) sont fabriqués avec un semi-conducteur dopé et/ou avec un composé intermétallique ;
dans lequel au moins 50 % en poids du matériau granulaire de la résistance électrique (103) est constitué de granulés de carbure de silicium ayant un dopage supérieur à 0,5 % et un diamètre compris entre 0,5 et 50 mm.

2. Appareil (100) selon la revendication précédente, dans lequel lesdits granulés de carbure de silicium sont des granulés de carbure de silicium noirs ou des granulés de carbure de silicium verts.

3. Appareil (100) selon la revendication 1 ou 2, dans lequel ladite au moins une résistance électrique (103) comprend des parties d'extrémité (103a, 103b), proches desdites électrodes (104a, 104b), ayant une résistivité électrique inférieure à une partie centrale (103c) entre lesdites parties d'extrémité (103a, 103b) ; de préférence, ladite résistivité inférieure est obtenue par au moins l'une des mesures suivantes : lesdites parties d'extrémité (103a, 103b) ayant une section transversale supérieure à ladite partie centrale (103c) et/ou lesdites parties d'extrémité (103a, 103b) comprenant un pourcentage en poids de granulés de matériau dopé ou intermétallique supérieur à celui de la partie centrale (103c) de ladite résistance électrique (103) et/ou comprenant des granulés de matériau dopé ou intermétallique ayant une dimension supérieure à celle des granulés de matériau dopé ou intermétallique situés dans ladite partie centrale (103c).

4. Appareil (100) selon l'une quelconque des revendications précédentes, dans lequel ladite résistance électrique (103) comprend également des granulés d'additifs constitués d'au moins 80 % en poids d'alumine, de magnésite et de silice.

5. Appareil (100) selon l'une quelconque des revendications précédentes, dans lequel lesdites électrodes (104a, 104b) sont au moins partiellement constituées d'un matériau choisi parmi : les alliages renforcés par une dispersion d'oxydes ; les alliages à base de nickel, les alliages à base de cobalt, les aciers inoxydables ferriques ; les matériaux réfractaires à base de carbure de silicium ; les matériaux réfractaires à base de disilicate de molybdène ; les matériaux réfractaires à base de chromite.

6. Appareil (100) selon l'une quelconque des revendications précédentes, comprenant au moins deux éléments de contact (106) mobiles entre une position de fonctionnement, dans laquelle ils sont reliés auxdites électrodes (104a, 104b) pour appliquer une différence de potentiel à ladite résistance électrique (103), et une position de repos, dans laquelle ils sont éloignés desdites électrodes (104a, 104b) pour inhiber ledit passage du courant électrique.

7. Appareil (100) selon l'une quelconque des revendications précédentes, dans lequel ladite pluralité de granulés de stockage (105) est configurée de manière à définir une zone de stockage primaire (105a) s'étendant autour de ladite au moins une résistance électrique (103) et adjacente à la résistance électrique (103) et une zone de stockage secondaire (105b), positionnée autour de ladite zone de stockage primaire (105a) et comportant une composition différente et une diffusion thermique inférieure à celle de la zone de stockage primaire (105a) ;
de préférence, ladite zone de stockage secondaire (105b) a une diffusion thermique inférieure à 1 mm2/s, de préférence inférieure à 0,6 mm2/s et encore plus préférablement inférieure à 0,4 mm2/s.

8. Appareil (100) selon la revendication précédente, dans lequel l'une desdites zones de stockage (105a, 105b), de préférence ladite zone de stockage secondaire (105b), est constituée d'au moins 90 % en poids de granulés ayant une granulométrie comprise entre 0,2 et 0,4 mm.

9. Appareil (100) selon la revendication 7 ou 8, dans lequel les granulés situés dans ladite zone de stockage primaire (105a) sont constitués d'au moins 80 % en poids d'alumine, de magnésite et de silice.

10. Appareil (100) selon l'une quelconque des revendications précédentes, comprenant un inducteur relié ou pouvant être relié en série à la résistance électrique (103) et configuré pour amortir les fluctuations soudaines d'un courant électrique dans ladite résistance électrique (103) et/ou pour compenser au moins partiellement la puissance réactive capacitive de ladite résistance électrique (103).

11. Appareil (100) selon l'une quelconque des revendications précédentes, dans lequel ladite au moins une résistance électrique (103) comporte, le long d'une direction d'extension (X) respective, une granulométrie et/ou une composition variable en fonction du poids de la masse de granulés au-dessus de la résistance électrique (103) de manière à maintenir une conductivité électrique sensiblement homogène le long de la résistance électrique (103).

12. Appareil (100) selon l'une quelconque des revendications précédentes, comprenant au moins une zone (107) de répartition du fluide interposée entre l'entrée (102a) et lesdits granulés de stockage (105) et/ou entre lesdits granulés de stockage (105) et la sortie (102b) et configurée pour favoriser une répartition homogène du fluide à travers la masse de granulés de stockage (105) ; et dans lequel ladite au moins une zone de répartition (107) est constituée d'un matériau poreux ayant une porosité au moins deux fois supérieure à celle de ladite pluralité de granulés de stockage (105) et/ou de granulés de répartition dans lesquels au moins 90 % en poids desdits granulés de répartition ont une dimension qui est deux fois supérieure à la dimension moyenne des granulés de stockage (105).

13. Procédé de stockage temporaire d'énergie thermique, réalisé à l'aide d'un appareil (100) selon l'une quelconque des revendications précédentes et comprenant les étapes de :
- alimenter électriquement ladite au moins une résistance électrique (103) générant de l'énergie thermique qui est stockée par les granulés de stockage (105), augmentant la température des granulés de stockage (105) ;
- transférer au moins une partie de l'énergie thermique stockée dans les granulés de stockage (105) par la circulation d'un fluide caloporteur de ladite entrée (102a) vers ladite sortie (102b) ;
dans lequel, entre les étapes d'alimentation électrique de la résistance électrique (103) et de transfert de l'énergie thermique au fluide caloporteur, il existe une étape de débranchement physique des électrodes (104, 104b) de la résistance électrique (103) et/ou d'une alimentation électrique externe de manière à interrompre les ponts physiques de dispersion thermique entre l'appareil et l'environnement extérieur.

14. Procédé selon la revendication précédente, comprenant également une étape de branchement de l'au moins une résistance électrique (103) à un bloc d'alimentation fournissant une tension d'alimentation d'au moins un ordre de grandeur supérieur à une tension d'alimentation utilisée dans un fonctionnement normal dudit appareil (100), de préférence ladite étape de branchement au bloc d'alimentation étant réalisée lors d'un démarrage à froid de l'appareil (100) ou pour augmenter temporairement la conductivité électrique de la résistance électrique (103) et/ou la puissance thermique générée.
